# EUROPEAN PATENT APPLICATION

(11) **EP 2 343 807 A1**
(43) Date of publication of application: **13.07.2011**
(21) Application number: 10150341.5
(22) Date of filing: 08.01.2010
(51) Int. Cl.: H03L 7/14

(54) **Method and interfaces for hitless reverting clock direction in synchronous copper based ethernet links**

(71) Applicant: Nokia Siemens Networks Oy, 02610 Espoo (FI)
(72) Inventor: Lovino, Luigi, 20134, Milano (IT); Santacesaria, Claudio, 20139, Milan (IT)

(57) **Abstract**

A copper based Gigabit Ethernet interface also called 1000BaseT, as specified by IEEE802.3 Clause 40, complies with the synchronous Ethernet method standardized in ITU-T G.8261 to convey synchronization information needed for end-to-end recovering of TDM flows or for other purposes. Accordingly, at the two ends of the four couples of balanced twisted pairs each bearing full-duplex transmissions, the transceivers share a reference clock. The two interfaces have direct access to the reference clock, nevertheless the negotiation is carried out the same at start up, and at the end the master role is assigned to one only interface, the other is slave and it loopback to the transmitter the reference clock recovered from the reception signal. In case of subsequent defects of synchronization, the two interfaces depart from negotiation and nearly simultaneously commutate their role in few microseconds. According to a first method, a TMN interface generates an out-of-band switching command towards additional clock switches. Following a second method, the interface in defect of synchronization transmits a signaling in-band of having commutated its role autonomously, the companion interface which receives this signaling switches immediately its role too, without sending back nothing to prevent endless cycles.

## Description

### FIELD OF THE INVENTION

The present invention relates to the field of Ethernet networks, and more precisely to a method and interfaces for hitless reverting clock direction in synchronous copper based Ethernet links.

The invention is particularly aimed to propose an upgrade of the actual standards mentioned at [Ref.1] and [Ref.2]. Used acronyms and bibliographic references are in Appendix.

### BACKGROUND ART

Although packet based communications, have been originally designed to convey non-synchronous information data over a link, in some applications devoted to provide the transport of packet data within synchronous TDM link, the availability of a common reference clock is necessary. Synchronous Ethernet is a method standardized by ITU-T recommendation at [Ref.2] adopted in packet networks for transferring a reference clock from a centralized high quality clock source to several distributed clock users.

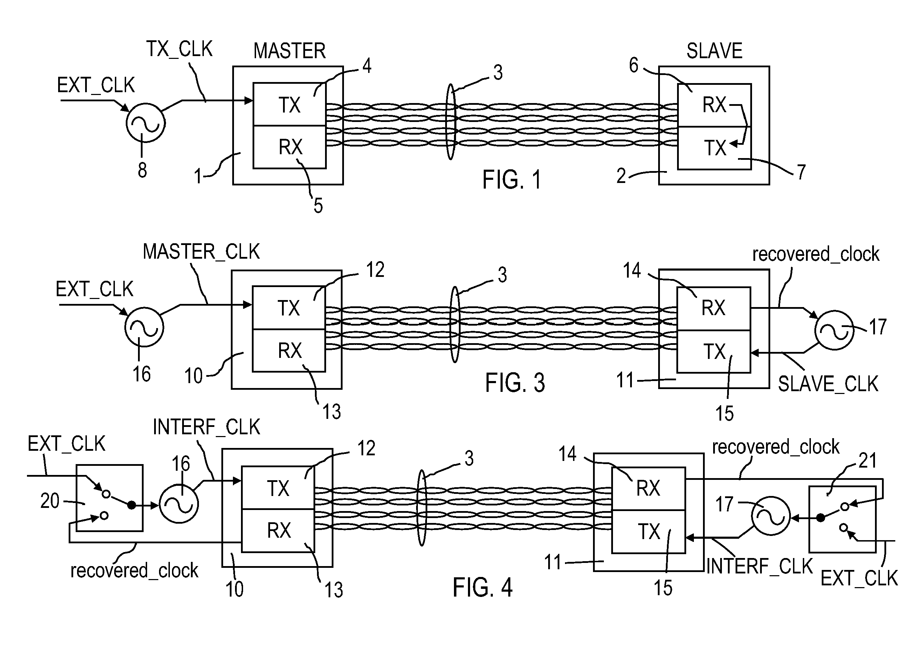

**Figure 1** is a very general schematic state-of-the-art representation of copper based Ethernet link between two Ethernet interfaces 1, 2 connected at two respective ends of a copper medium 3. Medium 3 is a cable which includes four balanced twisted pairs of copper wires. A repeater set extends the physical system topology by coupling two or more segments. Only one repeater is permitted within a single collision domain. The interface 1 includes a transmitter 4 and a receiver 5. The Interface 2 includes a transmitter 6 and a receiver 7. Medium 3 accounts for full-duplex transmission mode, as specified in [Ref.1], clause 40. Figure 1 is only aimed to outline clock synchronisation. A system clock TX_CLK is generated by an oscillator 8, eventually synchronized to a precise external reference clock EXT_CLK by means of a PLL. The oscillator/PLL 8 is located at the Master interface 1. The master clock TX_CLK synchronizes all data packets and signaling transmitted on link 3. At the slave interface 2, the receiver 6 recovers the master clock from the reception signal and loops it back to the Slave transmitter 7. The purpose of the repeater is to provide a simple, inexpensive, and flexible means of coupling two or more segments. A repeater set is an integral part of any Gigabit Ethernet network with more than two DTEs in a collision domain.

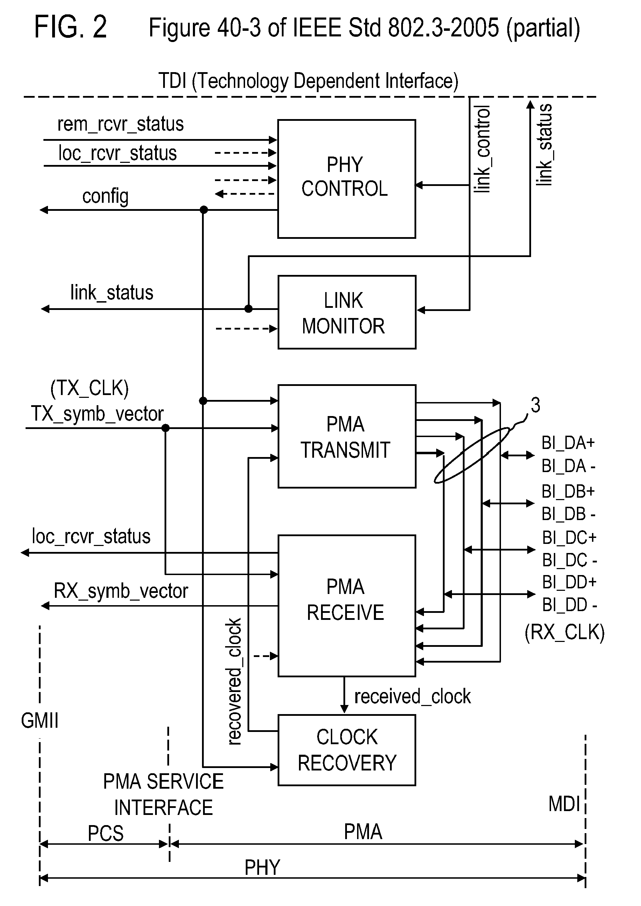

**Figure 2****,** excerpted from Figure 40-3 of [Ref.1], is a more detailed functional representation of the interface 1 or 2, indifferently. As known from [Ref.1], 1000BASE-T transfers data and control information across the following four service interfaces: GMII, PMA, MDI, and TDI each one with an its own set of primitives (called signals hereafter). Figure 2 is limited to the PMA at MDI, while PCS at GMII are not indicated. The PMA in the figure comprises one PMA Reset function (not indicated): and the following five simultaneous and asynchronous operating functions PHY CONTROL, LINK MONITOR, PMA TRANSMIT, PMA RCEIVE, and CLOCK RECOVERY. All operating functions are started immediately after the successful completion of the PMA Reset function. Limitedly to the scope of the of present description, only a subset of relevant signals (primitives) is shown. The PHY CONTROL block receives the following signals conveying link status and control indications: link_control, rem_rcvr_status, loc_rcvr_status, and generates a configuration signal "config" directed to an input of both PMA TRANSMIT block and CLOCK RECOVERY block. The LINK MONITOR block receives link_control signal too and generates a link_status signal in correspondence. The PMA TRANSMIT includes four transmitters of the symbol sequence TX_symb_vector originated from the incoming bitstream upon TX_CLK clock. The output of each transmitter is connected to a respective twisted pair out of the balanced four constituting the medium 3, to say: BI_DA+, BI_DA-; BI_DB+, BI_DB-; BI_DC+, BI_DC-; BI_DD+, BI_DD-. The PMA RCEIVE includes four receivers, the input of each being connected to a respective twisted pair of medium 3. A symbol sequence RX_symbol_vector is present at the collective output of the receivers and the loc_recvr_status signal is outputted. The CLOCK RECOVERY block is controlled by config signal to recover a local clock signal recovered_clock to be provided to the PMA TRANSMIT for synchronizing the transmission. Config signal configures the interface to operate either as a Master or as a Slave, being the Master role concerned to provide a reference clock for synchronization and set some parameters to the scrambler. The MASTER-SLAVE relationship between two stations sharing a link segment is established during Auto-Negotiation. Depending on the actual configuration set by config, the CLOCK RECOVERY block selects either TX_symb_vector or BI_D... in order to recover the transmission clock.

In operation, as said in [Ref.1], the 1000BASE-T meets the following objectives: supporting the CSMA/CD MAC; the 1000 Mb/s repeater; operation over 100 meters of copper balanced cabling; BER of less than or equal to 10⁻¹⁰, and Auto-Negotiation. The PHY employs full duplex baseband transmission over four pairs of Category 5 balanced cabling. The aggregate data rate of 1000 Mb/s is achieved by transmission at a data rate of 250 Mb/s over each wire pair. The use of hybrids and cancellers enables full duplex transmission by allowing symbols to be transmitted and received on the same wire pairs at the same time. Baseband signaling with a modulation rate of 125 MBd is used on each of the wire pairs. The transmitted symbols are selected from a four-dimensional 5-level symbol constellation. Each four-dimensional symbol can be viewed as a 4-tuple (An, Bn, Cn, Dn) of one-dimensional quinary symbols taken from the set {2, 1, 0, -1, -2}. The 1000BASE-T uses a continuous signaling system; in the absence of data, Idle symbols are transmitted. Idle mode is a subset of code-groups in that each symbol is restricted to the set {2, 0, -2} to improve synchronization. Five-level Pulse Amplitude Modulation (PAM5) is employed for transmission over each wire pair. The modulation rate of 125 MBd matches the GMII clock rate of 125 MHz and results in a symbol period of 8 ns.

The 1000BASE-T at [Ref.1] uses the link_status service primitive to exchange status indications, and the link_control service primitive to exchange control signals across the TDI. The PHY CONTROL and LINK MONITOR works together to coordinate all operations. PHY CONTROL generates the control actions that are needed to bring the PHY into a mode of operation during which frames can be exchanged with the link partner. PHY Control shall comply with a finite-state diagram of operation. LINK MONITOR determines the status of the underlying receive channel and communicates it via the variable link_status. Failure of the underlying receive channel typically causes the PMA's clients to suspend normal operation. The Link Monitor function shall comply with a finite-state diagram of operation.

Upon power on, reset, or release from power down, an Auto-Negotiation algorithm is used by 1000BASE-T devices to detect the abilities (modes of operation) supported by the device at the other end of a link segment, determine common abilities, and configure for joint operation. Auto-Negotiation is performed upon link start-up through the use of a special sequence of fast link pulses. If the presence of a remote 1000BASE-T station is established, the Auto-Negotiation algorithm permits full operation by setting link_control=ENABLE. As soon as reliable transmission is achieved, the variable link_status=OK is asserted, upon which further PHY operations can take place.

During normal operation the PMA couples messages from the PMA service interface onto the balanced cabling physical medium, and provides the link management and PHY Control functions. At the PCS the following two modes are operating: PCS TRANSMIT and PCS RCEIVE. The functions performed by the PCS TRANSMIT comprise the generation of continuous code-groups to be transmitted by the PMA TRANSMIT over the four channels of medium 3. The functions performed by the PCS RCEIVE comprise processing code-groups provided by the PMA RCEIVE from the remote PHY through medium 3. To achieve the indicated performance, it is highly recommended that PMA Receive include the functions of signal equalization, echo and crosstalk cancellation, and sequence estimation. The sequence of code-groups assigned to tx_symb_vector is needed to perform echo and self near-end crosstalk cancellation. The PMA Receive function uses the scr_status parameter and the state of the equalization, cancellation, and estimation functions to determine the quality of the receiver performance, and generates the variable loc_rcvr_status accordingly. Idle mode encoding takes into account the information of whether the local PHY is operating reliably or not and allows this information to be conveyed to the remote station by rem_rcvr-staus primitive. Further patterns are used for signaling a transmit error and other control functions during transmission of a data stream.

### OUTLINED TECHNICAL PROBLEM

Packet networks, for their nature asynchronous, are sometime based on rings, as commonly used in synchronous networks such as SDH. Besides, providing traffic protection, sometimes the ring is also required to propagate the synchronization information from a primary reference clock to all slave clocks in the network. In this case the ring is also required to provide a protection of the synchronization flow. Due to the intrinsic structure of the ring, after a failure occurred in a node, a reconfiguration of some nodes of the ring is necessary in order for the synchronization information to continue reaching all other nodes of the ring. Some nodes will therefore be reconfigured by a change of the synchronization direction from clockwise to counter-clockwise or vice versa. The said recommendation [Ref.1], leading to **figures 1** and **2****,** states also that the selection between Master and Slave must be done before traffic activation by means of the auto-negotiation procedure. It is possible to leave the two transceivers the possibility to randomly select which will become a Master and which will become a Slave; in alternative, it is possible to force manually a transceiver to be only Master or Slave. In the later case, still the auto-negotiation is needed for link activation and the two transceivers must be different type. No link activation is possible if both transceivers are forced to be Master or Slave during auto-negotiation.

Therefore, the state-of-the-art Ethernet transceivers provide the possibility of switching the clock direction only by performing a new auto-negotiation of the Ethernet parameters.

Such auto-negotiation of the interface parameters leads to a traffic interruption of 1 or 2 seconds. Such a traffic interruption may also interfere with the ring protection protocol, leading to a possibility of instability of the overall ring. No solution is foreseen today to the problem of traffic interruption, since reconfiguration leads to a temporary disruption of the traffic carried on the Ethernet interfaces.

### SUMMARY AND ADVANTAGES OF THE INVENTION

In view of the state of the art described, it is an object of the present invention to provide an arrangement to speed up clock resynchronization in synchronous Ethernet networks aimed to overcome the synchronization delay due to the Master/Slave auto-negotiation procedure.

The invention achieves said object by providing a synchronous Ethernet link between interfaces at the two ends of balanced twisted pairs, each Ethernet interface including:
- a baseband transmitter and a baseband receiver;
- means of generating a clock reference signal;
- means of recovering a clock reference from the received signal;
- switching means controllable to select either the clock reference signal or the recovered clock reference signal to synchronize the transmitter;
- control means configured to negotiate with the other Ethernet interface an initial configuration of the switching means,
in which according to the invention, the control means further include:
- means to detect a local clock-switch request coming from an ancillary signaling link provided by a telecommunication management network interface;
- means to issue upon detection of the clock-switch request a switch command, departing from negotiation, to the controllable switching means, as disclosed in claim 1.

Additional features of the present invention which are believed to be novel are set forth with particularity in the appended claims.

As known, an out-of-band signaling takes place when the Ethernet link, and more in general the whole synchronous Ethernet network transported inside a TDM ring, is monitored by a TMN, generally equipped with distributed OAM interfaces connected to the Ethernet interfaces by means of respective ancillary links bearing the agreed signaling. By comparison with Ethernet links without the TMN, a simplified ad hoc signaling can be used, because of the TMN transmits a clock switching command to both the Ethernet interfaces simultaneously.

In a realization of the invention, additional switching means are appositely provided to be triggered by said switch command departing from negotiation.

In a realization of the invention, a PLL is provided, and the additional switching means are controlled to forward to the reference input of the PLL a clock reference signal coming from a synchronization network or derivable from another synchronization source external to the link, and to forward to the clock input of the transmitter the clock reference at the output of the PLL.

In another realization of the invention, a PLL is provided, and the additional switching means are controlled to forward to the reference input of the PLL either the clock reference signal or the recovered clock reference signal, and to forward to the clock input of the transmitter the clock reference at the output of the PLL.

In another realization of the invention, a PLL is provided, and the additional switching means are controlled in order to assume the following alternative configurations :
- forward to the reference input of the PLL a clock reference signal coming from a synchronization network or derivable from another synchronization source external to the link, and to forward to the clock input of the transmitter the clock reference at the output of the PLL;
- forward to the reference input of the PLL either the clock reference signal or the recovered clock reference signal, and to forward to the clock input of the transmitter the clock reference at the output of the PLL;
- forward to the reference input of the PLL either the clock reference signal or the recovered clock reference signal, and forward to the clock input of the transmitter either the clock reference at the output of the PLL or said recovered clock reference signal.

In all realizations of above, the invention allows to switch the synchronization direction without the two interfaces have to be carry out any auto-negotiation, and therefore without any traffic interruption. Such a performance being named "hitless switch", borrowing a terminology of mechanical switches (unbounce relay's switches).

Profitably, as foreseen by the recommendation, the role of Master/Slave of the transceivers inside the respective interfaces is maintained, being this role necessary for functions other than synchronization, such as scrambling, but at both sides of the link the transceivers are sourced with an external clock; the external clock being selected between a local oscillator, as required in transceiver "clock Master" side, and the RX/TX loop, as required in transceiver "clock Slave" side.

The versatility of the invention is such to be implemented by means of ad hoc signaling traveling in-band when a TMN is not foreseen. According to a second embodiment of the invention suitable to the in-band signaling, the control means further include:
- means configured to detect a clock-switch condition over the link and upon detection, departing from negotiation:
   - issuing a switch command to the controllable switching means;
   - triggering the transmission of a remote-clock-switched signaling over the link;
- means configured to detect the remote-clock-clock-switched signaling, and upon detection:
   - triggering the sending of a switch command to the controllable switching means, as disclosed in an independent claim.

In a realization of the second embodiment of the invention, said "means configured to detect a clock-switch condition over the link", detect the syndrome of a synchronization defect from the local or remote received status or any type of signaling available to this purpose.

In an alternative realization of the second embodiment of the invention, said "means configured to transmit a remote-clock-switch request", are manually operated.

Profitably, said control means belong to the same integrated circuit which the transceiver belongs too.

Profitably, for the additional signaling and the relevant protocol a PICS can be submitted to the [Ref.1] standardization committee.

It can be appreciated that endless switch cycles are completely prevented in the second embodiment of the invention, since the "negotiation independent clock switch" is based on two different type of signalling, a first one locally generated and a second one remotely generated; in which, the second one doesn't imply a reply which could rebound the switch. The interface in trouble, independently of being master or slave, switches its reference clock and after a short delay informs the companion interface about it, so that the latter can switch in turn. It can be further appreciated that all additional means work independently one to another. Profitably, the completion of the two clock switches at the two interfaces only spans few microseconds, as each signalling message lasts 0.5 µs of the 64 bytes Ethernet frame. The very small switching delay is two order of magnitude lesser than the negotiation delay, thus it completely agrees with term "hitless" used to indicate the clock switch. The additional signalling has the usual format of the Ethernet signalling, except for the specific contents which is different from any logical configuration foreseen on the actual standards.

Further object of the invention is a method of synchronization of full-duplex baseband transmissions between Ethernet interfaces at the two ends of balanced twisted pairs supervised by a TMN, in which both Ethernet interfaces execute the step of selecting either a clock reference provided to the interface or a clock reference recovered from the received signal, on the basis of an initial negotiation with the other Ethernet interface, in which according to the invention both Ethernet interfaces further execute the following steps departing from negotiation:
- detecting a local clock-switch request coming from an ancillary signaling link provided by the TMN interface,
- switching to the other clock reference upon detection of said clock-switch request, as disclosed in an independent method claim.

Further object of the invention, which does not avail of a TMN, is a second embodiment of the method of synchronization, in which both Ethernet interfaces further execute the following steps departing from negotiation:
- detecting a clock-switch condition over the link and upon detection:
   - switching to the other clock reference,
   - triggering the transmission of a remote-clock-switched signaling over the link;
- detecting the remote-clock-switched signaling, and upon detection:
   - switching to the other clock reference, as disclosed in an independent method claim.

In a realization of the second embodiment of the method invention, said "detecting a clock-switch condition over the link", detect the syndrome of a synchronization defect from the local or remote received status.

In an alternative realization of the second embodiment of the invention, said "transmitting a remote-clock-switch request", is started manually.

### BRIEF DESCRIPTION OF THE DRAWINGS

The features of the present invention which are considered to be novel are set forth with particularity in the appended claims. The invention and its advantages may be understood with reference to the following detailed description of an embodiment thereof taken in conjunction with the accompanying drawings given for purely non-limiting explanatory purposes and wherein:
- **figure 1** is a very general schematic representation of a balanced twisted pairs (copper) Ethernet link between two Ethernet interfaces of the known art, in particular the art described in the actual release of [Ref.1];
- **figure 2** is a more detailed Ethernet interface, indifferently 1 or 2 of figure 1, corresponding to a partial functional block representation excerpted from [Ref.1], Figure 40-3;
- **figure 3** is a very general schematic representation of a (copper) Ethernet link encompassing four balanced twisted pairs interconnecting two Ethernet interfaces upgraded according to the present invention;
- **figure 4** is the link of figure 3 arranged to carry out symmetrical switches of Master-Slave clock configuration at the two interfaces;
- **figure 5** is a variant of the schematic representation of figure 3;
- **figure 6** is the link of figure 5 arranged to carry out symmetrical switches of Master-Slave clock configuration at the two interfaces;
- **figure 7** shows a detail of the PMA TRANSMIT functional block inside the Ethernet interface of figure 2, upgraded according to the present invention when a TMN interface is provided;
- **figure 8** shows a detail of the PHY CONTROL functional block inside the Ethernet interface of figure 2, upgraded according to the present invention when a TMN interface is not provided;
- **figure 9** shows a detail of the CKSEL2 functional block inside PHY CONTROL block of figure 8;
- **figure 10** shows a FSM diagram and its Inputs and States Tables, relevant to the operation of CKSEL2 functional block of figure 9.

### DETAILED DESCRIPTION OF AN EMBODIMENT OF THE INVENTION

**Figure 3** is a very general schematic representation of copper based Ethernet link, between two Ethernet interfaces 10 and 11 connected at two respective ends of the copper medium 3 (figure 1). The interface 1 includes a transmitter 12 and a receiver 13. The Interface 2 includes a transmitter 14 and a receiver 15. Medium 3 is used in full-duplex transmission mode. Figure 3 is only aimed to outline the clock synchronisation. A master clock MASTER_CLK is generated by an oscillator 16, eventually synchronized to a precise external reference clock EXT_CLK by means of a PLL. The oscillator/PLL 16 is located at the Master interface 1. The master clock MASTER_CLK synchronizes all data packets and signaling transmitted over the link 3. At the slave interface 11, the receiver 14 recovers the master clock from the received signal and generates a received clock signal "recovered_clock" forwarded to the reference input of a PLL 17, which generates in correspondence an interface-11's slave clock SLAVE_CLK synchronized to the recovered_clock. The slave clock SLAVE_CLK is looped back to the Slave transmitter 15.

The Ethernet link of figure 3 introduces the concept of "Master clock" and "Slave clock" as independent of the Master and Slave role as defined by the auto-negotiation procedure. Moreover the figure shows that the clock recovered by the receiver at the "Slave clock" interface is used to synchronize a PLL in equipment housing the "Slave clock". This PLL will provide the transmit clock to the transmitter at the "Slave clock" interface; this guarantees the synchronization between the two directions of transmissions.

The reversion of clock roles at the two interfaces is possible for the scheme of **figure 3** without performing a new auto-negotiation, just by reconfiguring the external hardware, as described in the next **figure 4****.**

Accordingly, in **figure 4** a first switch 20 is joined to the interface 10 of figure 3, and a second equal switch 21 is joined to the interface 11. The hardware configuration is the same at the two interfaces 10 and 11, being the only difference in the generation of a respective interface clock INTERF_CLK forwarded to the clock input of the local transmitter. Both switches 20 and 21 have two inputs and an output; the output is internally connectible (manually or electronically) either to one or the other input. One input of switch 20 is reached by the external clock reference signal EXT_CLK, while the other input is reached by a clock signal "recovered_clock" recovered by the receiver 13 from the reception signal. At the interface 10, the external clock EXT_CLK is turned at the output of switch 20, and the PLL 16 generates an interface clock INTERF_CLK which is the Master clock forwarded to the clock input of the transmitter 12. In this case the recovered_clock signal is unused. Although the auto-negotiation is not executed to the only aim of switching the clock, some form of coordination shall exist between the two interfaces, if nothing else as the paired interface 11 be informed about the needing of switching its transmission clock. In other word, a sort of synchronization shall exists between switches 20 and 21, and this will be detailed soon.

Supposing now that at the interface 11 the switch 21 is already synchronized to the new state of switch 20, we see that the recovered_clock signal is forwarded to the synchronization input of the PLL 21 and the external clock EXT_CLK is unused. The PLL 17 generates an interface clock INTERF_CLK which is the Slave clock forwarded to the clock input of the transmitter 15.

Clock switching as schematised in **figure 4** by means of mechanical switches, can be implemented in solid-state by integrating the switch into the same integrated circuit of the transceiver. Profitably, it requests a minimal modification of the switch already existing inside the PMA TRANSMIT block of figure 2 to select between recovered_clock and EXT_CLK. The switch can be operated manually or automatically, but in both cases a specific signaling shall be foreseen for the reciprocal synchronization at the two interfaces. The clock switching can be triggered when a fault is detected in the synchronization of the interface, either of master or slave clock. Provision are made to prevent switching rebounds from Master clock to Slave clock, or vice versa, which might lead to instability.

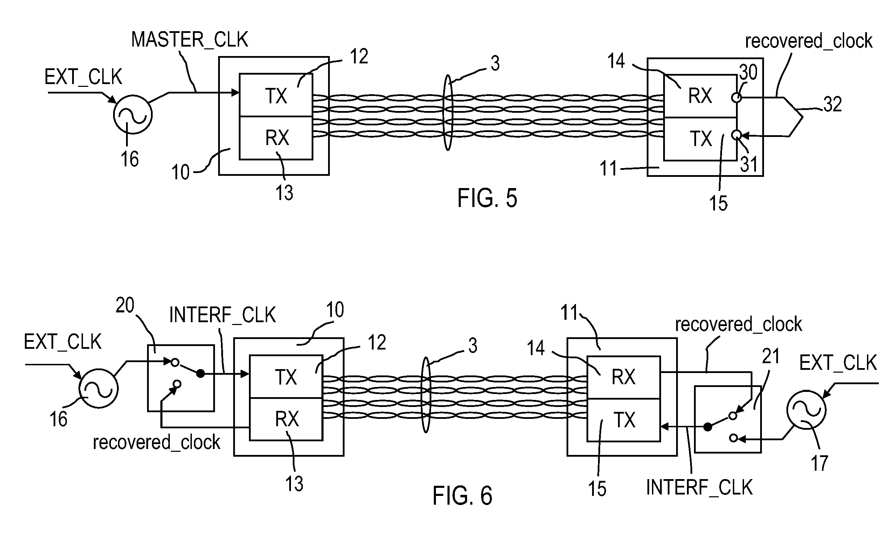

**Figure 5** shows an Ethernet link which differs from the Ethernet link of **Figure 3** for a PLL lacking at the side of interface 11, the presence of two sockets 30 and 31 and a clevis 32 between them. Socket 30 is connected to the output of the receiver 14 to bring the recovered_clock signal at the outside. The socket 31 is connected to clock input of the transmitter 15. The clevis 32 is a short cable equipped with two complementary plugs at the two ends. This configuration allows a direct loop back of the recovered clock in the "clock Slave" transceiver. The solution guarantees a fixed and deterministic phase between the RX and the TX clock.

**Figure 6** shows an Ethernet link which differs from the Ethernet link of **Figure 4** by the fact that: a) both PLLs are located upstream the respective switches instead of downstream; and b) the clevis 32 and the two sockets 30 and 31 have been replaced by a switch contact. Also in figure 6, the hardware configuration is the same at the two interfaces 10 and 11, being the only difference in the generation of a respective interface clock INTERF_CLK forwarded to the clock input of the local transmitter. More in detail, at the side of interface 10, one input of switch 20 is reached by a clock signal "recovered_clock" recovered by the receiver 13 from the reception signal, while the other input is reached by a clock signal at the output of the PLL 16 synchronized to the external reference clock signal EXT_CLK. At the interface 10, the reference clock signal at the output of PLL 16 is turned at the output of switch 20, as interface clock INTERF_CLK which is the Master clock forwarded to the clock input of the transmitter 12. In this case the recovered_clock signal is unused.

Supposing now that at the interface 11 switch 21 is already synchronized to the new state of switch 20, we see that the recovered_clock signal is the slave clock signal INTERF_CLK forwarded to the clock input of the transmitter 15 directly, while the clock signal at the output of PLL 17 is unused.

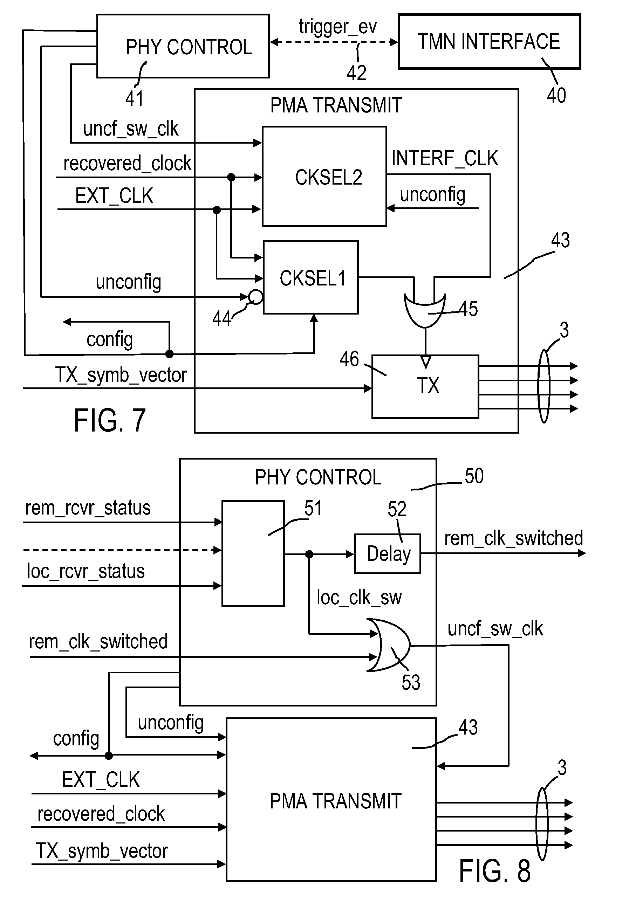

In operation, the Ethernet link of **figures 4** and **6** operate in accordance with two alternative embodiments, both of them having the same purpose to provide some ad hoc signaling to implement autonomous clock switching (without any auto-negotiation except the first) so that only a Master clock at a time is active on the link. In a first approach of **figure 7** a separate TMN is deployed parallelly to the TDM ring bearing all synchronous Ethernet links. In the alternative approach of **figure 8** the TMN is not foreseen, so the Ethernet link is used to convey additional signaling. With either the approaches some functional blocks of **figure 2** have to be upgraded accordingly.

The TMN generally includes a set of distributed management cards arranged redundantly to allow the system administrator to take complete control of the system using either one of the Distributed Management card interfaces. The Distributed Management card provides an administrative interface for the TMN. Functions include: setting up each of the system peripheral aggregators, - reconfiguring components, - Identifying faults, - and monitoring components.

With reference to **Figure 7****,** a TMN interface 40 is connected to a modified PHY CONTROL block 41 by means of a suitable link 42 that is independent of the Ethernet physical medium 3. The dashed line of link 42 means that the exact termination inside the Ethernet interface, despite the arrow to the PHY CONTROL, depends on the signaling protocol agreed to communicate between the TMN interface 40 and the Ethernet interface. In any case, upon detection of some synchronization defects in the supervised Ethernet link, or any faults on the link that can induce to change the actual reference clock inside an Ethernet interface, a trigger event "trigger_ev" is transmitted on link 42 to the PHY CONTROL block 41, either directly or indirectly. In reply the PHY CONTROL block 41 outputs a command uncf_sw_clk aimed to trigger a state commutation of the actual reference transmission clock, from master to slave, or vice versa. Parallelly, the TMN interface 40 sends the same trigger_ev signaling to the companion Ethernet interface, so as an opposite state commutation of actual reference transmission clock. is triggered. The PHY CONTROL block 41 outputs the usual config signal and a new unconfig signal, which shall not be confused with the config negated signal. The config and unconfig generation logic is charged to discriminate between events in which a negotiation is strictly necessary to re-synchronize the interface, and other events in which a faster re-synchronization seems preferable. Negotiation, and thus config, is better of being asserted at start-up when the role of Master and Slave of the two Ethernet interfaces is set first time. Afterwards, use of unconfig is preferable. The PMA TRANSMIT 43 is modified to include another clock selection block CKSEL2 other than the already existing CKSEL1. These two blocks operate alternatively thanks to the unconfig and unconfig negated signals which are mutually exclusive. The CKSEL2 receives: the external reference clock EXT_CLK, the recovered_clock signal, the uncf_sw_clk command, the unconfig signal, and when the latter is exerted, it selects either the first or the second clock to obtain at its output the transmission clock INTERF_CLK, which synchronizes the transmissions.

Both signals EXT_CLK and recovered_clock further reach two respective inputs of the clock selection block CKSEL1; two other inputs are reached by the config signal and the unconfig signal negated by a NOT gate 44. The output of CKSEL1 is inhibited (fixed to zero) when unconfig is asserted. The output signals of blocks CKSEL1 and CKSEL2 reach the two inputs of an OR gate 45, whose output signal is the reference clock directed to the clock input of the transmitter 46 (either 12 or 15), which transmits the baseband signal TX_symb_vector on medium 3. The hardware described allows to preserve other usages of the config signal other than re-synchronization by CKSEL2.

With reference to **Figure 8****,** while the PMA TRANSMIT block 43 is unchanged, the PHY CONTROL block 50 is modified in respect of the previous block 42 in a way to include some additional hardware for generating by itself the trigger command uncf_sw_clk directed to the PMA TRANSMIT 43. To meet this aim both signaling rem_rcvr_status and loc_rcvr_status, so as further signaling relevant to discover a synchronization defect inside the interface, are conveyed to a logical block 51 inside the PHY CONTROL block 50. Block 51 generates in correspondence a local trigger signal loc_clk_sw, which, after being delayed by a delay 52, becomes a remote trigger signal rem_clk_switched, submitted to the PCS TRANSMIT function in order to be sent to the companion interface. The loc_clk_sw signaling is branched to a first input of an OR gate 53, whose second input is reached by the rem_clk_switched signaling coming from the other interface. At the output of OR gate 53 the uncf_sw_clk command is directed to the PMA TRANSMIT 43 to trigger the commutation of reference clock. In operation, the two trigger signals loc_clk_sw and rem_clk_switched are independently generated at the two inputs of the OR gate 53, being these two trigger signals originated by synchronization defects discovered inside a respective interface. The PHY CONTROL block 50 further generates the config and unconfig signals both directed to the PMA TRANSMIT as said above.

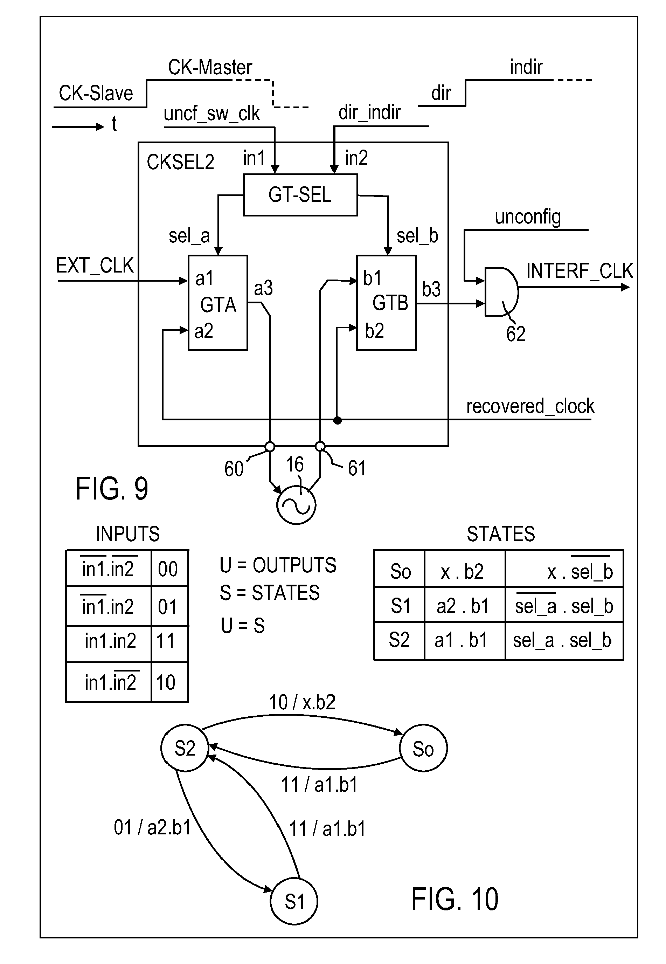

The detail of clock selection block CKSEL2 is shown in **figure 9****,** in which a first two-input multiplexer GTA and a second two-input multiplexer GTB are controlled by a FSM logic block GT-SEL. The ensemble of the three elements gets together into a single interface the two switching configurations shown in the **figures 4** and **6****.** With reference to figure 9, the reference signal EXT_CLK reaches a first input a1 of multiplexer GTA while the recovered_clock signal reaches the second input a2. The output of multiplexer GTA is connected to a socket 60, in its turn connectible to the reference input of an external PLL 16, whose output is connectible to another socket 61 of CKSEL2. The latter is internally connected to an input b1 of multiplexer GTB, whose other input b2 is reached by the recovered _clock signal. The output of multiplexer GTB is connected to an input of a two-input AND gate 62, whose other input is reached by the unconfig signal. The gate 62 outputs the transmission clock signal INTERF_CLK when the unconfig signal is asserted, otherwise the output is fixed to zero. The FSM's logic block GT-SEL has two inputs in1 and in2 and two outputs sel_a and sel_b connected to the control input of multiplexers GTA and GTB, respectively. The input in1 of GT-SEL logic is reached by the uncf_sw_clk signal; the other input in2 is reached by a selection signal dir_indir used to discriminate between the two configurations of **figure 4** and **6****.** On top of the figure the waveforms of uncf_sw_clk and dir_indir signals are depicted. These signals assume two only logical values either asserted or negated. In presence of a negated value of uncf_sw_clk a slave clock is selected, while for an asserted value the master clock is selected instead. In presence of a negated value of dir_indir signal the configuration of **figure 6** called "dir" (direct) is selected, while for an asserted value the configuration of **figure 4** called "indir" (indirect) is selected instead.

The operation of the FSM embodied in the circuitry of **figure 9** is illustrated in **figure 10** by means of a finite state diagram, an INPUTS Table, a STATES Table, and an equation U (outputs) = S (states). The table of INPUTS reports the four logical combinations assumed by the uncf_sw_clk and the dir_indir signals, or in equivalent manner the logical values at the inputs in1 and in2 of GT-SEL. Only three states So, S1, and S2 are possible in the STATES table, the two (S1, S2) corresponding to the two switch configurations of figure 4 and the only different state (So) of figure 6. Close to each transition branch the value of the inputs and the corresponding output configuration of switches GTA and GTB are indicated. The finite state diagram correctly shows that there are not transitions between the two different slave states and the transition departing from a slave state always conducts to the master state.

Although the invention has been described with particular reference to a preferred embodiment, it will be evident to those skilled in the art, that the present invention is not limited thereto, but further variations and modifications may be applied without departing from the scope of the invention as defined by the annexed claims.

### ACRONYMS

- BER: Bit Error Ratio
- CSMA/CD: Carrier Sense Multiple Access
- CD: Collision Detection
- DTE: Data Terminal Equipment
- ESD: End-of-Stream Delimiter
- FSM: Finite State Machine
- GMII: Gigabit Media Independent Interface
- GPS: Global Positioning System
- MAC: Media Access Control
- MBd: Mega baud
- MDI: Media Dependent Interface
- OAM: Operation Administration Maintenance
- PAM: Pulse Amplitude Modulation
- PLL: Phase Locked Loop
- SynchE: Synchronous Ethernet
- PCS: Physical Coding Sublayer
- PHY: Physical Layer
- PICS: Protocol Implementation Conformance Statement
- PMA: Physical Medium Attachment
- SSD: Start-of-Stream Delimiter
- TDI: Technology Dependent Interface
- TDM: Time Division Multiplex
- TMN: Telecommunication Management Network
- TX: Transmitter
- RX: Receiver
- SDH: Synchronous Digital Hierarchy

### REFERENCES

[1] ITU-T G.8261/Y.1361 (04/2008): Timing and synchronization aspects in packet networks.
[2] IEEE802.3: Part 3: Carrier Sense Multiple Access with Collision Detection (CSMA/CD) access method and physical layer specifications.

## Claims

1. Synchronous Ethernet link between interfaces (10, 11) at the two ends of balanced twisted pairs (3), each Ethernet interface including:
- a baseband transmitter (12, 15) and a baseband receiver (13, 14);
- means of generating a clock reference signal (EXT_CLK);
- means of recovering (CLOCK RECOVERY) a clock reference from the received signal;
- switching means (CKSEL1) controllable to select either the clock reference signal (EXT_CLK) or the recovered clock reference signal to synchronize the transmitter;
- control means (PHY CONTROL) configured to negotiate with the other Ethernet interface (11, 10) an initial configuration of the switching means (CKSEL1),
**characterized in that**, the control means further includes:
- means to detect a local clock-switch request (trigger_ev) coming from an ancillary signaling link (42) provided by a telecommunication management network interface (40);
- means to issue upon detection of the clock-switch request a switch command (uncf_sw_clk), departing from negotiation, to the controllable switching means (CKSEL2).

2. Synchronous Ethernet link according to claim 1, **characterized in that** additional switching means (20, 21, CKSEL2) are appositely provided to be controlled by said switch command (uncf_sw_clk) departing from negotiation.

3. Synchronous Ethernet link according to claim 2, **characterized in that** said means of generating a clock reference signal include a PLL (16), and the additional switching means (20, 21, CKSEL2) are controlled to forward to the reference input of the PLL a clock reference signal (EXT_CLK) coming from a synchronization network or derivable from another synchronization source external to the link, and to forward to the clock input of the transmitter (12, 15, 46) the clock reference at the output of the PLL (16).

4. Synchronous Ethernet link according to claim 2, **characterized in that** a PLL (16) is provided, and the additional switching means (20, 21, CKSEL2) are controlled to forward to the reference input of the PLL either said clock reference signal (EXT_CLK) or the recovered clock reference signal, and to forward to the clock input of the transmitter (12, 15, 46) the clock reference at the output of the PLL.

5. Synchronous Ethernet link according to claim 2, **characterized in that** a PLL (16) is provided, and the additional switching means (GTA, GTB, GT-SEL) are controlled in order to either:
- forward to the reference input of the PLL (16) a clock reference signal (EXT_CLK) coming from a synchronization network or derivable from another synchronization source external to the link (3), and forward to the clock input of the transmitter (12, 15, 46) the clock reference at the output of the PLL; or
- forward to the reference input of the PLL (16) either the clock reference signal (EXT_CLK) or the recovered clock reference signal, and forward to the clock input of the transmitter (12, 15, 46) the clock reference at the output of the PLL; or
- forward to the reference input of the PLL (16) either the clock reference signal (EXT_CLK) or the recovered clock reference signal, and forward to the clock input of the transmitter (46) either the clock reference at the output of the PLL or said recovered clock reference signal.

6. Synchronous Ethernet link between interfaces (10, 11) at the two ends of balanced twisted pairs (3), each Ethernet interface including:
- a baseband transmitter (12, 15) and a baseband receiver (13, 14);
- means of generating a clock reference signal (EXT_CLK);
- means of recovering (CLOCK RECOVERY) a clock reference from the received signal;
- switching means (CKSEL1) controllable to select either the clock reference signal (EXT_CLK) or the recovered clock reference signal to synchronize the transmitter;
- control means (PHY CONTROL) configured to negotiate with the other Ethernet interface an initial configuration of the switching means (CKSEL1),
**characterized in that**, the control means further include:
- means configured to detect a clock-switch condition over the link and upon detection, departing from negotiation:
- issuing a switch command (loc_clk_sw, uncf_sw-clk) to the controllable switching means (CKSEL2);
- triggering the transmission of a remote-clock-switched signaling (rem_clk_switched) over the link (3);
- means configured to detect the remote-clock-switched signaling, and upon detection:
- triggering the sending of a switch command (uncf_sw-clk) to the controllable switching means (CKSEL2).

7. Synchronous Ethernet link according to claim 6, **characterized in that** said means (PHY CONTROL) configured to detect a clock-switch condition over the link, detect the syndrome of a synchronization defect from the local or remote received status or any type of signaling available to this purpose.

8. Synchronous Ethernet link according to claim 6, **characterized in that** said means configured to transmit a remote-clock-switched signaling (rem_clk_switched) over the link (3) are manually operated.

9. Method of synchronization of full-duplex baseband transmissions between Ethernet interfaces (10, 11) at the two ends of balanced twisted pairs (3) supervised by a telecommunication management network, in which both Ethernet interfaces execute the step of:
- selecting either a clock reference (EXT_CLK) provided to the interface or a clock reference recovered from the received signal on the basis of an initial negotiation with the other Ethernet interface,
**characterized in that** both Ethernet interfaces further execute the following steps departing from negotiation:
- detecting a local clock-switch request coming from the ancillary signaling link provided by a telecommunication management network interface (40);
- switching to the other clock reference upon detection of said clock-switch request.

10. Method of synchronization of full-duplex baseband transmissions between Ethernet interfaces (10, 11) at the two ends of balanced twisted pairs (3) in which both Ethernet interfaces execute the step of:
- selecting either a clock reference (EXT_CLK) provided to the interface or a clock reference recovered from the received signal on the basis of an initial negotiation with the other Ethernet interface,
**characterized in that** both Ethernet interfaces further execute the following steps departing from negotiation:
- detecting a clock-switch condition over the link and upon detection:
- switching to the other clock reference,
- transmitting a remote-clock-switched signaling (rem_clk_switched) over the link (3);
- detecting the remote-clock-switched signaling, and upon detection:
- switching to the other clock reference.
